# EUROPÄISCHE PATENTANMELDUNG

(11) **EP 1 608 064 A1**
(43) Veröffentlichungstag der Anmeldung: **21.12.2005**
(21) Anmeldenummer: 04013908.1
(22) Anmeldetag: 14.06.2004
(51) Int. Cl.: H03K 7/08

(54) **Treiberschaltung für Pulsbreitenmodulation**

(71) Anmelder: Delphi Technologies, Inc., Troy, MI 48007 (US)
(72) Erfinder: Kamali, Dogan, 51643 Gummersbach (DE)
(74) Vertreter: Manitz, Finsterwald & Partner GbR

(57) **Zusammenfassung**

Eine integrierte Treiberschaltung umfasst einen PBM (Pulsbreitenmodulation)-Generator zur Erzeugung eines in Abhängigkeit von einem Eingangssignal pulsbreitenmodulierten Signals, wenigstens einen über das pulsbreitenmodulierte Signal ansteuerbaren verstärkenden Ausgangskanal, dem eine Last zugeordnet ist, sowie einen einen CAN (Controller Area Network)-Controller umfassenden Prozessor für eine CAN-basierte Kommunikation zwischen verschiedenen Elementen des Treibermoduls und/oder mit anderen Modulen.

## Beschreibung

Die Erfindung betrifft eine Treiberschaltung mit wenigstens einem pulsbreitenmodulierten Ausgangskanal.

Bei einer Vielzahl von Anwendungen sind Ausgangskanäle erforderlich, die über eine Pulsbreitenmodulation (PBM), auch Pulslängenmodulation genannt, ansteuerbar sind. Sind nun aber nur analoge oder digitale Ausgänge vorgesehen, die nicht über PBM-Signale ansteuerbar sind, so muss eine Elektronik eingesetzt werden, durch die ein analoges oder einem D/A-Wandler zugeführtes Digitalsignal in ein PBM-Signal mit einer spezifischen PBM-Frequenz und einem variablen Tastverhältnis umgewandelt werden kann. Die meisten Anwendungen, bei denen eine solche Elektronik erforderlich ist, dienen der Ansteuerung von beispielsweise hydraulischen Ventilen. Hier müssen die Spulen mit PBM-Signalen angesteuert werden, wobei eine Antwort über die jeweiligen Ventilzustände erforderlich ist, was bedeutet, dass jeweils ein Stromsensor eingesetzt werden muss. Es existiert derzeit nun aber keinerlei Elektronik, bei der diese verschiedenen Funktionen in einem Modul verwirklicht sind.

Der Erfindung liegt die Aufgabe zugrunde, eine verbesserte Treiberschaltung der eingangs genannten Art zu schaffen, bei der die zuvor genannten Probleme beseitigt sind. Dabei soll die Treiberschaltung insbesondere so ausgelegt sein, dass möglichst sämtliche der verschiedenen Funktionen in einem einzigen Modul integrierbar sind.

Diese Aufgabe wird nach der Erfindung gelöst durch eine integrierte Treiberschaltung mit einem PBM (Pulsbreitenmodulation)-Generator zur Erzeugung eines in Abhängigkeit von einem Eingangssignal pulsbreitenmodulierten Signals, wenigstens einem über das pulsbreitenmodulierte Signal ansteuerbaren verstärkenden Ausgangskanal, dem eine Last zugeordnet ist, sowie mit einem einen CAN (Controller Area Network)-Controller umfassenden Prozessor für eine CAN-basierte Kommunikation zwischen verschiedenen Elementen des Treibermoduls und/oder mit anderen Modulen.

Aufgrund dieser Ausbildung können die verschiedenen Funktionen des Treibermoduls in einem einzigen Modul integriert sein. Aufgrund der CAN (Controller Area Network)-basierten Kommunikation ist die erfindungsgemäße integrierte Treiberschaltung mit besonderem Vorteil insbesondere in Fahrzeugen bzw. Kraftfahrzeugen einsetzbar.

So handelt es sich bei dem CAN-Netzwerk (Controller Area Network) um ein serielles Kommunikationsprotokoll, das auf wirksame Weise eine verteilte Steuerung unter Sicherstellung eines sehr hohen Sicherheitsniveaus unterstützt. Wie bereits erwähnt ist ein solches CAN-Netzwerk insbesondere für einen Einsatz im Bereich der Fahrzeugelektronik geeignet. Es kann auf kostengünstige Weise in die Fahrzeugelektronik eingebaut werden, um den üblicherweise benötigten umfangreichen Kabelbaum zumindest teilweise zu ersetzen.

Bei der Pulsbreitenmodulation (PBM), auch Pulslängenmodulation genannt, handelt es sich um ein analoges Modulationsverfahren, bei dem eine direkte Beziehung zwischen der variablen Breite oder Dauer periodisch gesendeter Impulse und dem momentanen Wert des Eingangs- oder Nutzsignals besteht. Beim ummodulierten Signal sind die Pulsbreite, die Pulsdauer und die Pulsamplitude gleichbleibend konstant. Wird ein solches Trägersignal durch eine entsprechende Information moduliert, verändert sich nur die Pulsbreite, während die beiden anderen Parameter, d.h. die Pulsdauer und die Pulsamplitude, unverändert bleiben.

Bei dem dem PBM-Generator zugeführten Eingangssignal handelt es sich also bevorzugt um ein Analogsignal, wobei das Tastverhältnis des vom PBM-Generator erzeugten pulsbreitenmodulierten Signals bevorzugt in Abhängigkeit von der Amplitude dieses analogen Eingangssignals vaiierbar ist.

Vorteilhafterweise ist zur CAN-basierten Kommunikation mit wenigstens einem anderen Modul ein CAN-Bus vorgesehen. Somit ist insbesondere auch eine solche Ausführung denkbar, bei der eine für das Eingangssignal repräsentative CAN-Nachricht durch ein anderes Modul erzeugt wird und über den CAN-Bus dem Prozessor zuführbar ist, um ein entsprechendes Eingangssignal an den PBM-Generator zu liefern.

Bei einer bevorzugten praktischen Ausführungsform der erfindungsgemäßen integrierten Treiberschaltung ist wenigstens ein durch einen MOSFET-Kanal gebildeter, über das pulsbreitenmodulierte Signal ansteuerbarer Ausgangskanal vorgesehen. Dabei kann beispielsweise wenigstens ein die Last über die Seite höheren Potentials treibender MOSFET-Kanal (High Side Driven MOSFET) und/oder wenigstens ein die Last über die Seite niedrigeren Potentials treibender MOSFET-Kanal (Low Side Driven MOSFET) vorgesehen sein.

Dem Ausgangskanal bzw. der betreffenden Last kann zweckmäßigerweise ein Stromsensor zugeordnet sein. Ein solcher Stromsensor kann ein Rückkopplungssignal insbesondere an den einen CAN-Controller umfassenden Prozessor liefern. Über den CAN-Bus kann das vom Stromsensor gelieferte Signal als CAN-Nachricht insbesondere auch an andere CAN-Busteilnehmer übertragen werden.

Die PBM-Frequenz ist zweckmäßigerweise über einen dem PBM-Generator zugeordneten Kondensator einstellbar.

Bei einer bevorzugten praktischen Ausführungsform der erfindungsgemäßen integrierten Treiberschaltung erfolgt zumindest im Wesentlichen die gesamte Ansteuerung eines jeweiligen Ausgangskanals über den vom Eingangssignal beaufschlagten PBM-Generator ggf. unter Einbeziehung des vom Stromsensor gelieferten Rückkopplungssignals auf der Basis einer CAN-Kommunikation.

Die Last kann beispielsweise ein vorzugsweise hydraulisches Ventil umfassen.

Die erfindungsgemäße integrierte Treiberschaltung kann also insbesondere einen PBM-Generator umfassen, der PBM-Signale mit einem in Abhängigkeit von einem analogen Eingangssignal variablen Tastverhältnis erzeugt. Der Ausgang des PBM-Generators kann z.B. mit dem Eingang eines High-Side- oder Low-Side-MOSFET-Ausgangskanal verbunden werden. Diesen MOSFET-Kanälen bzw. den betreffenden Lasten kann optional jeweils mit ein Stromsensor zugeordnet sein, der ein Rückkopplungssignal liefert, das beispielsweise für den Zustand eines vorzugsweise hydraulischen Ventils repräsentativ ist. Alle diese Funktionen können insbesondere auf der Basis einer CAN-Kommunikation verwirklicht sein, wobei die Eingangssignale für den PBM-Generator beispielsweise auch auf der Basis von CAN-Nachrichten erzeugt werden können, die von einem anderen Modul an die integrierte Treiberschaltung gesendet wurden, und wobei die vom Stromsensor gelieferten Signale über entsprechende CAN-Nachrichten an andere CAN-Bus-Teilnehmer gesendet werden können.

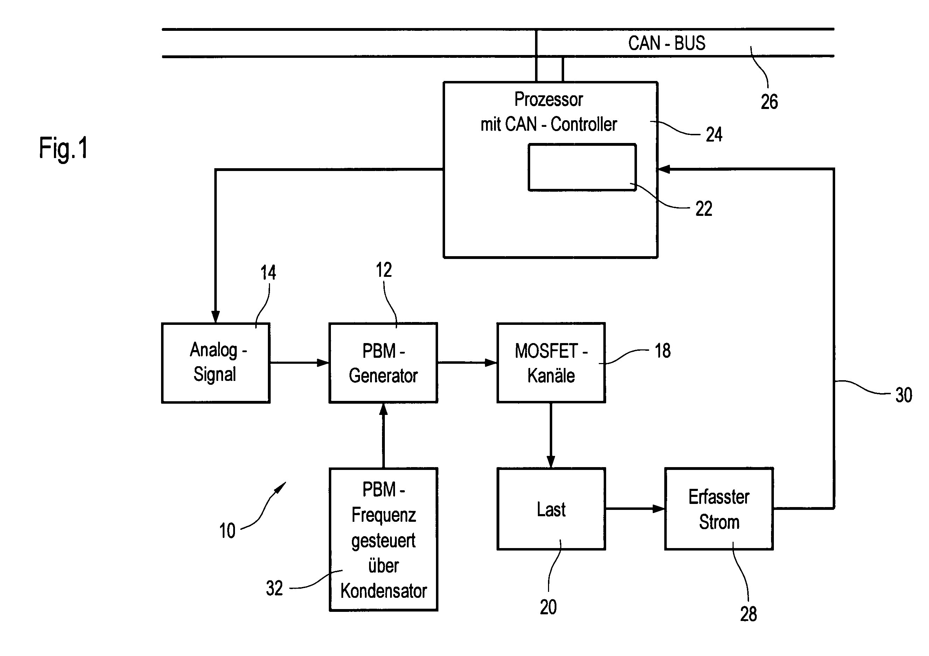

Die Erfindung wird im Folgenden anhand eines Ausführungsbeispiels unter Bezugnahme auf die Zeichnung näher erläutert.

Die einzige Figur der Zeichnung zeigt ein vereinfachtes Blockschaltbild einer rein beispielhaften Ausführungsform einer erfindungsgemäßen integrierten Treiberschaltung 10.

Danach umfasst die integrierte Treiberschaltung 10 einen PBM (Pulsbreitenmodulation)-Generator 12 zur Erzeugung eines in Abhängigkeit von einem Eingangssignal 14 pulsbreitenmodulierten Signals 16, wenigstens einen über das pulsbreitenmodulierte Signal 16 ansteuerbaren verstärkenden Ausgangskanal 18 mit zugeordneter Last 20 sowie einen einen CAN (Controller Area Network)-Controller 22 umfassenden Prozessor 24 für eine CAN-basierte Kommunikation zwischen den verschiedenen Elementen des Treibermoduls 10 und/oder mit anderen Modulen.

Bei dem erfindungsgemäß eingesetzten CAN-Netzwerk (Controller Area Network) handelt es sich um ein serielles Kommunikationsprotokoll, das auf effiziente Weise eine verteilte Echtzeitsteuerung unter Sicherstellung eines sehr hohen Sicherheitsniveaus unterstützt. Ein solches CAN-Netzwerk kann mit besonderem Vorteil insbesondere im Bereich der Automobilelektronik eingesetzt werden. Es kann auf kostengünstige Weise insbesondere auch nachträglich in bereits vorhandene Automobilelektronik eingebaut werden, um insbesondere den bisher recht umfangreichen Kabelbaum zumindest teilweise zu ersetzen.

Bei der Pulsbreitenmodulation (PBM), auch Pulslängenmodulation genannt, handelt es sich um ein analoges Modulationsverfahren, bei dem eine direkte Beziehung zwischen der variablen Breite oder Dauer periodisch gesendeter Impulse und dem momentanen Wert des Eingangs- oder Nutzsignals besteht. Beim unmodulierten Signal sind die Pulsbreite, die Pulsdauer und die Pulsamplitude gleichbleibend konstant. Wird ein solches Trägersignal durch das Eingangs- oder Nutzsignal wurde entsprechend moduliert, verändert sich in der Regel nur die Pulsbreite, während die beiden anderen Parameter, d.h. die Pulsdauer und die Pulsamplitude unverändert bleiben.

Bei dem Eingangssignal handelt es sich demnach in der Regel um ein Analogsignal. Liegt ein digitales Signal vor, so kann dieses beispielsweise über einen D/A-Wandler zunächst in ein Analogsignal umgewandelt werden. Das Tastverhältnis des vom PBM-Generator 12 erzeugten pulsbreitenmodulierten Signals 16 ist bevorzugt in Abhängigkeit von der Amplitude des analogen Eingangssignals 14 variierbar.

Über einen CAN-Bus 26 ist insbesondere auch eine CAN-basierte Kommunikation mit wenigstens einem anderen Modul möglich. Somit kann beispielsweise eine für das Eingangssignal 14 repräsentative CAN-Nachricht durch ein anderes Modul erzeugt und über den CAN-Bus 26 dem Prozessor 24 zugeführt werden, um ein entsprechendes Eingangssignal 14 an den PBM-Generator 14 zu liefern.

Es können insbesondere ein oder mehrere jeweils durch einen MOSFET-Kanal gebildete, über ein jeweiliges pulsbreitenmoduliertes Signal 16 ansteuerbare Ausgangskanäle 18 vorgesehen sein. Dabei kann beispielsweise wenigstens ein die Last 20 über die Seite höheren Potentials treibender MOSFET-Kanal 18 (High Side Driven MOSFET) und/ oder wenigstens ein die Last 20 über die Seite niedrigeren Potentials treibender MOSFET-Kanal 18 (Low Side Driven MOSFET) vorgesehen sein.

Dem jeweiligen Ausgangskanal 18 bzw. der betreffenden Last 20 kann insbesondere ein Stromsensor 28 zugeordnet sein.

Ein solcher Stromsensor 28 kann beispielsweise ein Rückkopplungssignal 30 an den einen CAN-Controller 22 umfassenden Prozessor 24 liefern. Das vom Stromsensor 28 gelieferte Signal 30 kann über den CAN-Bus 26 als CAN-Nachricht insbesondere auch an andere CAN-Busteilnehmer übertragen werden.

Die PBM-Frequenz ist bevorzugt über einen dem PBM-Generator 12 zugeordneten Kondensator 32 einstellbar.

Vorteilhafterweise erfolgt zumindest im Wesentlichen die gesamte Ansteuerung eines jeweiligen Ausgangskanals 18 über den vom Eingangssignal 14 beaufschlagten PBM-Generator 12 ggf. unter Einbeziehung eines Rückkopplungssignals 30 auf der Basis einer CAN-Kommunikation.

Die Last 20 kann insbesondere ein vorzugsweise hydraulisches Ventil umfassen.

Es ist also ein PBM-Generator 12 vorgesehen, der PBM-Signale mit einer in Abhängigkeit vom einem analogen Eingangssignal variablen Tastverhältnis erzeugen kann. Der Ausgang des PBM-Generators 12 kann z.B. mit dem Eingang eines High-Side- oder Low-Side-MOSFET-Ausgangskanals verbunden werden. Den MOSFET-Ausgangskanälen 18 bzw. den betreffenden Lasten 20 kann ein jeweiliger Stromsensor zugeordnet sein, der ein Rückkopplungssignal bildet, das beispielsweise repräsentativ für den Zustand eines vorzugsweise hydraulischen Ventils sein kann. Alle diese Funktionen können auf einer CAN-Kommunikation basieren, so dass beispielsweise die den PBM-Generator 12 beaufschlagenden Eingangssignale 14 über eine CAN-Nachricht von einem anderen Modul stammen können und beispielsweise die über einen jeweiligen Stromsensor 28 erfassten Signale über eine CAN-Nachricht auch an andere CAN-Bus-Teilnehmer gesendet werden können.

### Bezugszeichenliste

- 10: integrierte Treiberschaltung
- 12: PBM-Generator
- 14: Eingangssignal
- 16: pulsbreitenmoduliertes Signal
- 18: Ausgangskanal
- 20: Last
- 22: CAN-Controller
- 24: Prozessor
- 26: CAN-Bus
- 28: Stromsensor
- 30: Signal, Rückkopplungssignal
- 32: Kondensator

## Patentansprüche

1. Integrierte Treiberschaltung (10) mit einem PBM (Pulsbreitenmodulation)-Generator (12) zur Erzeugung eines in Abhängigkeit von einem Eingangssignal (14) pulsbreitenmodulierten Signals (16), wenigstens einem über das pulsbreitenmodulierte Signal (16) ansteuerbaren verstärkenden Ausgangskanal (18), dem eine Last (20) zugeordnet ist, sowie mit einem einen CAN (Controller Area Network)-Controller (22) umfassenden Prozessor (24) für eine CAN-basierte Kommunikation zwischen verschiedenen Elementen des Treibermoduls und/oder mit anderen Modulen.

2. Integrierte Treiberschaltung nach Anspruch 1,
**dadurch gekennzeichnet,**
**dass** das Eingangssignal (14) ein Analogsignal ist.

3. Integrierte Treiberschaltung nach Anspruch 2,
**dadurch gekennzeichnet,**
**dass** das Tastverhältnis des vom PBM-Generator (12) erzeugten pulsbreitenmodulierten Signals (16) in Abhängigkeit von der Amplitude des analogen Eingangssignals variierbar ist.

4. Integrierte Treiberschaltung nach einem der vorhergehenden Ansprüche,
**dadurch gekennzeichnet,**
**dass** zur CAN-basierten Kommunikation mit wenigstens einem anderen Modul ein CAN-Bus (26) vorgesehen ist.

5. Integrierte Treiberschaltung nach Anspruch 4,
**dadurch gekennzeichnet,**
**dass** eine für das Eingangssignal (14) repräsentative CAN-Nachricht durch ein anderes Modul erzeugt und über den CAN-Bus (26) dem Prozessor (24) zuführbar ist, um ein entsprechendes Eingangssignal (14) an den PBM-Generator (12) zu liefern.

6. Integrierte Treiberschaltung nach einem der vorhergehenden Ansprüche,
**dadurch gekennzeichnet,**
**dass** wenigstens ein durch einen MOSFET-Kanal gebildeter, über das pulsbreitenmodulierte Signal (16) ansteuerbarer Ausgangskanal (18) vorgesehen ist.

7. Integrierte Treiberschaltung nach Anspruch 6,
**dadurch gekennzeichnet,**
**dass** wenigstens ein die Last (20) über die Seite höheren Potentials treibender MOSFET-Kanal (18) (High Side Driven MOSFET) vorgesehen ist.

8. Integrierte Treiberschaltung nach Anspruch 6 oder 7,
**dadurch gekennzeichnet,**
**dass** wenigstens ein die Last (20) über die Seite niedrigeren Potentials treibender MOSFET-Kanal (18) (Low Side Driven MOSFET) vorgesehen ist.

9. Integrierte Treiberschaltung nach einen dem vorhergehenden Ansprüche,
**dadurch gekennzeichnet,**
**dass** dem Ausgangskanal (18) bzw. der betreffenden Last (20) ein Stromsensor (28) zugeordnet ist.

10. Integrierte Treiberschaltung nach Anspruch 9,
**dadurch gekennzeichnet,**
**dass** der Stromsensor (28) ein Rückkopplungssignal (30) an den einen CAN-Controller (22) umfassenden Prozessor (24) liefert.

11. Integrierte Treiberschaltung nach Anspruch 9 oder 10,
**dadurch gekennzeichnet,**
**dass** das vom Stromsensor (28) gelieferte Signal (30) über den CAN-Bus (26) als CAN-Nachricht an andere CAN-Bus-Teilnehmer übertragbar ist.

12. Integrierte Treiberschaltung nach einen dem vorhergehenden Ansprüche,
**dadurch gekennzeichnet, dass** die PBM-Frequenz über einen dem PBM-Generator (12) zugeordneten Kondensator (32) einstellbar ist.

13. Integrierte Treiberschaltung nach einen dem vorhergehenden Ansprüche,
**dadurch gekennzeichnet,**
**dass** zumindest im wesentlichen die gesamte Ansteuerung des Ausgangskanals (18) über den vom Eingangssignal (14) beaufschlagten PBM-Generator (12) gegebenenfalls unter Einbeziehung eines Rückkopplungssignals (30) auf der Basis einer CAN-Kommunikation erfolgt.

14. Integrierte Treiberschaltung nach einen dem vorhergehenden Ansprüche,
**dadurch gekennzeichnet,**
**dass** die Last (20) ein vorzugsweise hydraulisches Ventil umfasst.
